# EUROPÄISCHE PATENTSCHRIFT

(11) **EP 2 694 838 B1**
(45) Veröffentlichungstag und Bekanntmachung des Hinweises auf die Patenterteilung: **03.12.2014**
(21) Anmeldenummer: 12714959.9
(22) Anmeldetag: 30.03.2012
(51) Int. Cl.: F16F 15/00

(54) **VORRICHTUNG ZUR MECHANISCHEN SCHWINGUNGSENTKOPPLUNG**
DEVICE FOR DECOUPLING MECHANICAL VIBRATIONS
DISPOSITIF DE DECOUPLAGE DE VIBRATIONS MECANIQUES

(30) Priorität: 01.04.2011 DE 102011015800
(43) Veröffentlichungstag der Anmeldung: 12.02.2014
(73) Patentinhaber: Fraunhofer Gesellschaft zur Förderung der angewandten Forschung E.V., 80686 München (DE)
(72) Erfinder: BARTEL, Torsten, 64285 Darmstadt (DE); MELZ, Tobias, 64285 Darmstadt (DE)
(74) Vertreter: Rösler, Uwe
(86) Internationale Anmeldenummer: PCT/EP2012/001442
(87) Internationale Veröffentlichungsnummer: WO 2012/130474

(56) Entgegenhaltungen:
- FR-A1- 2 900 144
- JP-A- 58 050 337
- US-A- 2 932 482
- US-A- 3 185 428
- US-A- 5 645 260

## Beschreibung

### Technisches Gebiet

Die Erfindung bezieht sich auf eine Vorrichtung zur mechanischen Schwingungsentkopplung, mit zwei Lagerenden, an die jeweils gegenseitig schwingungszuentkoppelnde Körper fügbar oder gefügt sind und die über eine Koppelstruktur mit einer variabel einstellbaren Steifigkeit miteinander verbunden sind.

### Stand der Technik

Gilt es einen Körper möglichst schwingungsarm zu lagern, bspw. einen Körper gegenüber in der Körperumgebung vorherrschenden Schwingungen zu isolieren, oder die Übertragung der Anregung eines schwingenden Körpers auf die Umgebung zu unterbinden, so bedient man sich in an sich bekannter Weise einer Vorrichtung zur mechanischen Schwingungsentkopplung kurz Lager, das über eine Koppelstruktur mit einer möglichst geringen Steifigkeit verfügt. Als sog. passive Lager werden Vorrichtungen zur mechanischen Schwingungsentkopplung bezeichnet, deren Koppelstruktur über eine unveränderbare Steifigkeit, bspw. gegeben durch ein Feder- oder Gummielement, vorgegeben ist. Durch die fest vorgegebene Lagersteifigkeit weisen insbesondere passive Lager den Nachteil einer sog. Schwingungsüberhöhung bei Eintritt der Resonanzfrequenz des schwingend gekoppelten Systems auf. Im Resonanzfall kommt es zu maximalen Schwingungsamplituden, die zu einer erhöhten Lärmbelästigung sowie zu erheblichen Strukturschwächungen der über das Lager gekoppelten Körper führen. Diesem Nachteil wird durch eine Erhöhung der Dämpfung entgegengetreten, wodurch sich jedoch die Wirkung der Schwingungsentkopplung bei höheren Frequenzen verschlechtert.

Demgegenüber sehen aktive Lager die Möglichkeit der Veränderung der Steifigkeit der zwischen beiden, schwingungszuentkoppelnden Körpern gefügten Koppelstruktur vor. Aktive Lager weisen üblicherweise eine durch eine Grundsteifigkeit charakterisierte Koppelstruktur, einen den aktuellen Schwingungszustand erfassbaren Sensor sowie einen die Steifigkeit der Koppelstruktur beeinflussenden Aktor. Im Wege einer geregelten Krafteinleitung durch den Aktor auf die Steifigkeit des aktiven Lagers kann die Schwingungserhöhung im Resonanzfall vermindert werden, ohne dabei die Isolationswirkung bei höheren Frequenzen, wie im Falle eines passiven Lagers, nachhaltig zu beeinträchtigen.

Als Beispiel für ein aktives Lager wird auf die US 5,645,260 verwiesen, aus der eine aktive Lagereinheit für eine schwingungsberuhigte Lagerung einer Nutzmasse gegenüber einem schwingenden Untergrund hervorgeht. Die Nutzmasse ist hierbei am oberen Teil eines S-förmig gebogenen Aluminium-Bügels befestigt, dessen unteres Ende am vibrierenden Untergrund fest verbunden ist. Der S-förmig gebogene Aluminiumbügel weist sowohl einen horizontal sowie auch vertikal orientierten Bügel-Abschnitt auf. Längs beider Bügel-Abschnitte sind jeweils FlächenPiezoaktoren appliziert. Zur Schwingungsdämpfung der über den Aluminium-Bügel gegenüber dem vibrierenden Untergrund gelagerten Nutzmasse werden die horizontal und vertikal applizierten Flächenpiezoaktoren mit geeigneten Steuersignalen beaufschlagt, durch die der betreffende horizontal und vertikal orientierte Bügel-Bereich eine entsprechend dynamische Versteifung erfährt, durch die eine Schwingungsübertragung von Seiten des schwingenden Untergrundes zur Nutzmasse abgeschwächt bzw. vollständig unterbunden wird.

Dokument US 5,645,260 offenbart den Oberbegriff des Anspruchs.

Die Druckschrift DE 690 32 856 T2 beschreibt ein Schwingungsdämpfungssystem, mit dem Schwingungen mit sehr kleiner Amplitude gedämpft werden können, speziell im Niederfrequenzbereich. Im Prinzip besteht das Schwingungsdämpfungssystem aus einer Vertikaldämpfungseinrichtung und einer Horizontaldämpfungseinrichtung, deren Steifheiten Null oder nahezu Null betragen. Die Vertikaldämpfungseinrichtung besitzt als wesentliches Bestandteil ein dreiarmiges Federelement, in dessen Mitte die Last angreift. Die Steifigkeit der Federelemente wird durch radial von außen auf die "Arme" wirkende Kräfte so eingestellt, dass eine Netto-Steifheit von nahezu Null erreicht wird. Zur Einstellung der radialen Kräfte dienen die Lastbiegungseinrichtungen, die jeweils zwei federbalkenartige Biegungseinrichtungen, welche zwischen einem Mittelstück und zwei Enden und angeordnet sind. Die Enden sind ortsfest über sog. Abstandsblöcke mit der Basis verbunden.

Die EP 1 927 782 A1 offenbart einen aktiven Tilger mit einem Biegebalken, der eine Tilgermasse mit einer Befestigungsvorrichtung verbindet. Auf mindestens einer Seite des Biegebalkens ist ein piezoelektrischer Aktor angeordnet, der eine Biegung des Biegebalkens bewirkt. Diese erzeugt eine Kraft auf die Befestigungsstruktur, die schwingungsdämpfend wirkt.

Die DE 10 2005 043 429 A1 beschreibt eine Vorrichtung zur Schwingungsentkopplung mit einer Sensor-Aktoreinheit, die ein lastbedingtes Schwingen eines Mittels erfasst und dem Schwingen des Mittels aktorisch entgegenwirkt. Sensoren bzw. Aktoren können einen Wandlerwerkstoff, z.B. ein piezoelektrisches Material aufweisen.

Die US 3 185 428 A beschreibt ein Lager, das eine translatorische Bewegung in drei Raumrichtungen erlaubt, dagegen eine Rotation unterbindet. Das Lager besteht aus vier gegenseitig beweglichen Teilen, nämlich aus einer Basis und drei ineinander geschachtelten Rahmen. Die Basis ist mit einer beliebigen Stützstruktur verbunden. Auf dem innersten Rahmen ist die Last angeordnet. Der Rahmen kann sich in alle Raumrichtungen, d.h. in zwei horizontalen Richtungen und in vertikaler Richtung bewegen, ohne jedoch drehbar bzgl. einer vertikalen Drehachse zu sein. Die inneren Rahmen sind jeweils zum äußerlich umgebenden Rahmen mit einem an gegenüberliegenden Rahmenseiten angeordneten Paar von Blattfedern abgestützt, wobei das Blattfederpaar zwischen dem innersten und dem zweiten Rahmen um 90° versetzt zu dem anderen Blattfederpaar angeordnet ist. Jede Blattfeder ist mit einem Ende an dem jeweils innenliegenden Rahmen befestigt und mit ihrer Mitte an dem jeweils außenliegenden Rahmen. Der äußerste Rahmen ist über senkrecht angeordneten Blattfedern mit der Basis verbunden.

Die AT 345 042 B offenbart einen Federsatz zur konzentrischen, federnden Führung oszillierend bewegter Bauteile mittels parallel gerichteter und durch Abstandselemente an ihren Enden gegeneinander fixierter Federelemente, wobei der Federsatz jeweils aus einem Federpaar aus parallel angeordneten Federn und aus einer hierzu senkrecht angeordneten, einzelnen Feder besteht.

Die US 2 932 482 A zeigt eine Anordnung mit zwei zueinander orthogonal angeordneten Blattfederpaaren, die nur translatorische, und keine rotatorischen, Bewegungen zweier Objekte gegeneinander erlauben soll.

### Darstellung der Erfindung

Der Erfindung liegt die Aufgabe zugrunde, eine Vorrichtung zur mechanischen Schwingungsentkopplung, mit zwei Lagerenden, an die jeweils gegenseitig schwingungszuentkoppelnde Körper fügbar oder gefügt sind und die über eine Koppelstruktur mit einer variabel einstellbaren Steifigkeit miteinander verbunden sind, derart weiterzubilden, dass eine dreidimensionale Schwingungsentkopplung zwischen beiden über die Koppelstruktur verbundenen Körpern möglich wird. Die hierfür erforderliche Vorrichtung soll kompakt und möglichst frei skalierbar ausgebildet sein. Darüber hinaus soll der konstruktive sowie auch regelungstechnische Aufwand zur Schwingungsentkopplung möglichst minimiert werden.

Die Lösung der der Erfindung zugrunde liegenden Aufgabe ist im Anspruch 1 angegeben. Den Erfindungsgedanken in vorteilhafter Weise weiterbildende Merkmale sind Gegenstand der Unteransprüche sowie der weiteren Beschreibung insbesondere unter Bezugnahme auf das dargestellte Ausführungsbeispiel zu entnehmen.

Lösungsgemäß ist eine Vorrichtung zur mechanischen Schwingungsentkopplung, mit zwei Lagerenden, an die jeweils gegenseitig schwingungszuentkoppelnde Körper fügbar oder gefügt sind und die über eine Koppelstruktur mit einer variabel einstellbaren Steifigkeit miteinander verbunden sind, derart weitergebildet, dass die Koppelstruktur wenigstens drei Federbalkenelemente aufweist, deren jeweils zuordenbare Federbalkenfläche durch einen Normalenvektor charakterisiert ist und die jeweils formstabil längs und elastisch orthogonal zur Federbalkenfläche sind. Ferner sind die wenigstens drei Federbalkenelemente räumlich zueinander derart angeordnet, dass deren Normalenvektoren jeweils einen Winkel α, mit α = 90°±30°, einschließen, vorzugsweise α = 90°, d.h. dass die Normalenvektoren orthogonal zueinander orientiert sind. Die einzelnen Federbalkenelemente sind jeweils an ihren zwei sich gegenüberliegenden Federbalkenenden an einem Einspannmittel fest eingespannt. Hierbei sind jeweils ein erstes und ein letztes Einspannmittel mit einem der beiden Lagerenden verbunden, wohingegen die übrigen Einspannmittel jeweils zwei Federbalkenelemente miteinander fest verbinden. Die übrigen Einspannmittel sind hingegen ausschließlich von den Federbalkenelementen getragen und ansonsten frei schwingend gelagert.

Die lösungsgemäße Vorrichtung zur mechanischen Schwingungsentkopplung ermöglicht eine schwingungsentkoppelte bzw. schwingungsgedämpfte Lagerung zweier Körper relativ zueinander um jeweils drei vorzugsweise orthogonal zueinander ausgerichtete Raumachsen. Längs jeder einzelnen Raumachse ist jeweils wenigstens ein separat ausgebildetes Federbalkenelement angeordnet, dessen Federsteifigkeit durch Material, Form und Größe bestimmt ist. Je nach Einsatz- und Anwendungsfall ist es vorteilhaft die wenigstens drei Federbalkenelemente hinsichtlich ihrer Federsteifigkeit individuell, d. h. unterschiedlich auszubilden. Durch die separate Ausbildung jedes einzelnen Federbalkenelementes ist es möglich, längs der drei vorzugsweise orthogonal orientierten Raumrichtungen unterschiedliche und individuell ausgewählte Federsteifigkeiten einzurichten.

Die wenigstens drei Federbalkenelemente sind jeweils längs ihrer stirnseitig gegenüberliegenden Federbalkenenden in mechanische Einspannmittel fest gelagert. Somit ist jedes einzelne Federbalkenelement beidseitig mechanisch gefesselt, wodurch sich am Ort der Einspannung systembedingt jeweils ein Schwingungsknoten ausbildet. Die Einspannmittel bestehen aus einem starren, unnachgiebigen Material, d.h. sie Verformen sich nicht trotz der über die Federbalkenelemente auf die Einspannmittel einwirkenden Kräfte und Momente. Auf diese Weise ist gewährleistet, dass die gegenseitige Raumlage zweier über ein Einspannmittel verbundener Federbakenelemente konstant bleibt.

Neben einer individuellen Ausbildung jedes einzelnen Federbalkenelementes und einer damit einhergehenden individuellen Federbalkenfestigkeit, ist es besonders vorteilhaft längs wenigstens eines Federbalkenelementes, vorzugsweise längs aller Federbalkenelemente ein Mittel zur Beeinflussung der Flächensteifigkeit und/oder der Dämpfung vorzusehen. Das Mittel zur Beeinflussung der Steifigkeit und/oder der Dämpfung orthogonal zur Federbalkenfläche weist wenigstens ein Wandlermaterial auf, das durch eine Formänderung elektrischer Energie zu erzeugen in der Lage ist bzw. durch Applikation elektrischer Energie geometrische Formänderungen zu generieren vermag. Besonders geeignet hierzu sind flächig ausgebildete Piezoaktoren, die oberflächig auf die Federbalkenfläche applizierbar sind oder innerhalb des Federbalkenelementes integriert sind. Letztere Möglichkeit bietet sich an, bei der Ausbildung der Federbalkenelemente aus einem Flächenverbundmaterial, das über eine Sandwichstruktur verfügt. Üblicherweise bietet es sich an, die Federbalkenelement aus metallischen Werkstoffen, vorzugsweise Federstahl zu fertigen.

Zur Beeinflussung der Steifigkeit des Federbalkenelementes gilt es die Mittel in Abhängigkeit einer Stellwegänderung des jeweiligen Federbalkenelementes anzusteuern. Um einen Einfluss auf die Dämpfung zu erhalten, werden die Mittel in Abhängigkeit der Geschwindigkeit, mit der das Federbalkenelement Deformationen in Form von Schwingungen unterliegt, angesteuert.

Für die Realisierung eines adaptronischen, d. h. sich selbständig an das aktuelle Schwingungsverhalten anpassenden Schwingungsentkoppler ist es erforderlich, längs wenigstens eines Federbalkenelementes einen den aktuellen Schwingungszustand erfassenden Sensor sowie einen den Schwingungszustand längs des Federbalkenelementes beeinflussenden Aktor vorzusehen. Nicht notwendigerweise ist es erforderlich den Sensor längs der Federbalkenelemente anzubringen, ebenso ist es denkbar zur Erfassung des aktuellen Schwingungszustand eine hierfür erforderliche Sensorik am Ort der Lagerenden oder gar an den schwingenden Körpern, die es relativ zueinander über die Koppelstruktur zu lagern gilt, anzubringen.

Eine bevorzugte Ausführungsform sieht jeweils zwei parallel geführte, getrennt voneinander angeordnete Federbalkenelemente vor, die zwischen zwei Einspannmitteln eingespannt sind. Durch die doppelte Auslegung der zwischen zwei Einspannmittel verlaufenden Federbalkenelemente kann zum einen die zwischen den Einspannmitteln wirkende Flächensteifigkeit beeinflusst werden, zum anderen jedoch wird eine weitgehende Parallelauslenkung der über die beiden Federbalkenelemente miteinander verbundenen Einspannmittel mechanisch erzwungen. Durch die geschilderte Doppelauslegung der Federbalkenelemente zwischen jeweils zwei Einspannmitteln werden somit Auslenktrajektorien, die sich aus Drehbewegungsanteilen um das jeweilige Einspannmittel herrühren wesentlich unterdrückt.

Die kompakte Bauform der lösungsgemäßen Vorrichtung zur mechanischen Schwingungsentkopplung eröffnet darüber hinaus die Möglichkeit mehrere einzelne lösungsgemäß ausgebildete Vorrichtungen zur mechanischen Schwingungsentkopplung modular miteinander zu kombinieren, um auf diese Weise mehraxial aufgebaute aktive Lagereinheiten zu realisieren. So lassen sich nach dem Baukastenprinzip wenigstens zwei lösungsgemäß ausgebildete Vorrichtungen zur Schwingungsentkopplung entweder im Rahmen einer seriellen oder parallelen Kopplung miteinander verbinden. Im Falle einer seriellen Kopplung ist das jeweils zweite Lagerende der ersten Vorrichtung fest mit dem ersten Lagerende der zweiten Vorrichtung gekoppelt. Im Falle einer Parallelkopplung werden die jeweils ersten Lagerenden und die jeweils zweiten Lagerenden beider Vorrichtungen fest miteinander gekoppelt.

### Kurze Beschreibung der Erfindung

Die Erfindung wird nachstehend ohne Beschränkung des allgemeinen Erfindungsgedankens anhand von Ausführungsbeispielen unter Bezugnahme auf die Zeichnungen exemplarisch beschrieben. Es zeigen:
- Fig. 1: schematisierte Darstellung einer Koppelstruktur mit drei in serieller Abfolge über Einspannmittel verbundene Blattfederelemente,
- Fig. 2a, b, c, d: Anordnungsmöglichkeiten von Aktoren/Sensoren auf einem Federbalkenelement
- Fig. 3: Illustration zur doppelten Ausgestaltung zweier parallel zwischen zwei Einspannmitteln angeordneter Federbalkenelemente sowie
- Fig. 4: perspektivische Darstellung einer realisierten Koppelstruktur.

### Wege zur Ausführung der Erfindung, gewerbliche Verwendbarkeit

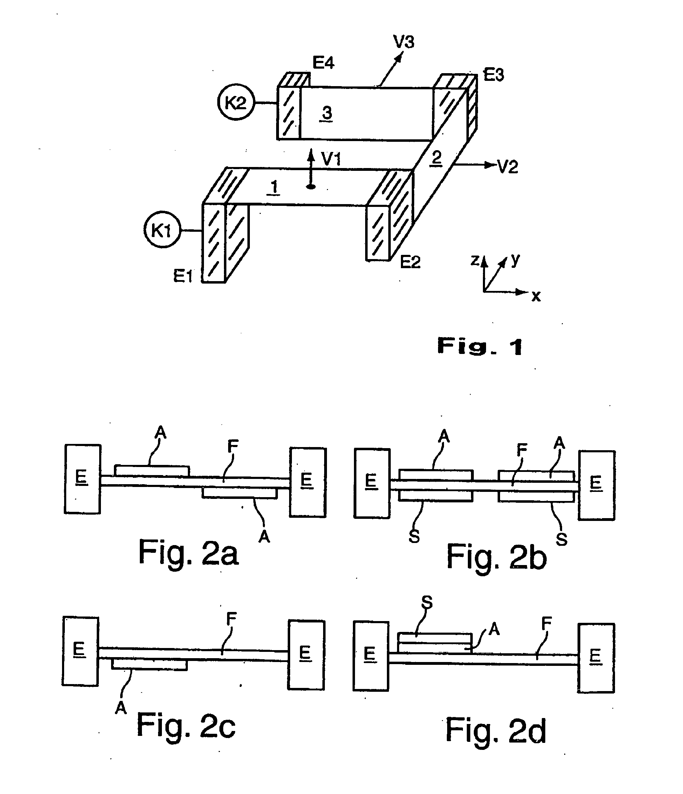

Figur 1 zeigt eine schematisierte Darstellung zur Illustration einer lösungsgemäß ausgebildeten Koppelstruktur, wie sie zur Schwingungsentkopplung zwischen zwei Körpern K1, K2 vorzusehen ist. So sei angenommen, dass das Einspannmittel E1 einseitig mit einem Körper K1 verbunden ist und an das andererseits ein Federbalkenelementende eines ersten Federbalkenelementes 1 fest angebracht ist. Das Federbalkenelement 1 ist als Flächenelement ausgebildet und weist typischerweise eine rechteckförmig ausgebildete Federbalkenfläche auf, deren zugeordneter Flächennormalenvektor V1 in dem angegebenen Beispiel gemäß Figur 1 in z-Richtung orientiert ist. Neben dem Ausführungsbeispiel in Figur 1 ist hierzu ein kartesisches Koordinatensystem mit den darin festgelegten Raumachsen x-y-z illustriert. Das dem Einspannmittel 1 gegenüberliegende Federelementende des Federbalkenelementes 1 ist am Einspannmittel 2 befestigt. Ebenfalls mit dem Einspannelement E2 fest verbunden ist ein Federbalkenelementende des Federbalkenelementes 2, dessen Federbalkenfläche orthogonal zur Federbalkenfläche des Federbalkenelementes 1 orientiert ist und somit einen in x-Richtung orientierten Flächennormalenvektor V2 aufweist. Im Weiteren ist das dem Einspannmittel 2 gegenüberliegende Federbalkenelementende des Federbalkenelementes 2 mit dem Einspannmittel E3 fest verbunden. Das Einspannmittel 3 seinerseits ist wiederum mit einem Federbalkenelementende des dritten Federbalkenelementes 3 verbunden, das letztlich mit dem Einspannmittel E4 verbunden ist, an dem der zweite Körper K2 angebracht ist. Die Federbalkenfläche des dritten Federbalkenelementes 3 weist einen Flächennormalenvektor V3 auf, der in y-Richtung und somit ebenfalls orthogonal zu den Flächennormalenvektoren V1 und V2 orientiert ist.

Aus der schematischen Darstellung gemäß Figur 1 kann entnommen werden, dass die Einspannmittel E2 und E3 ausschließlich von den Federbalkenelementen 1 bis 3 getragen werden und ansonsten frei schwingend gelagert sind.

Die Federbalkenelemente 1, 2 und 3 sind nicht notwendigerweise in Form, Größe und Material identisch ausgebildet, sondern unterscheiden sich je nach Einsatz- und Anwendungsfall voneinander, um letztlich unterschiedliche Flächensteifigkeiten relativ zu den jeweiligen durch die Raumachsen x, y und z vorgegebenen Raumrichtungen zu erhalten.

Für eine während des Betriebes zur Schwingungsentkopplung autonom vornehmbaren Variation der Flächensteifigkeit, vorzugsweise jedes einzelnen Federbalkenelementes, befindet sich auf der Oberfläche vorzugsweise jedes Federbalkenelementes ein aus Wandlermaterial bestehender Aktor A, vorzugsweise ein flächig ausgebildeter Piezoaktor, der durch Applikation elektrischer Energie eine Formänderung erfährt, wodurch die Flächensteifigkeit des jeweiligen Federbalkenelementes beeinflusst werden kann. In den Figuren 2a bis d sind unterschiedliche Anordnungsformen von Aktoren A sowie auch Sensoren S längs der Oberfläche eines Federbalkenelementes F illustriert. Dargestellt sind jeweils Längsschnittbilder durch ein zwischen zwei Einspannmitteln E, E beidseitig fest eingespanntes des Federbalkenelement F. Figur 2a zeigt zwei an unterschiedlicher Flächenoberseite applizierter Piezoaktoren A, Figur 2b zeigt eine Kombination aus Aktoren A und Sensoren S, die jeweils wechselseitig an den sich gegenüberliegenden Oberseiten des Federbalkenelementes 1 angebracht sind. Figur 2c zeigt lediglich eine einseitige Applikation eines Aktors A auf der Oberflächenunterseite eines Federbalkenelementes F, Figur 2d zeigt eine SandwichStruktur aus Aktor A und Sensor S in unmittelbarer Abfolge auf einer Oberseite des Flächenelementes F. Mit Hilfe oberflächig applizierter oder innerhalb des Federbalkenelementes F integrierter piezoelektrischer Aktoren ist eine unmittelbare Einflussnahme auf die Flächensteifigkeit jedes einzelnen Federbalkenelementes F möglich.

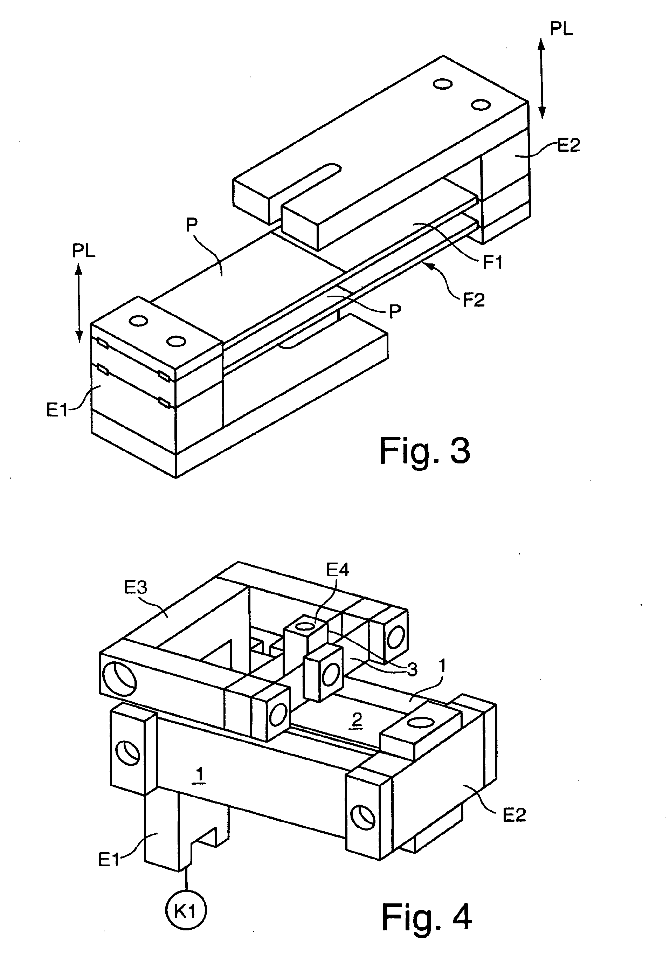

Figur 3 zeigt die Einspannung zweier parallel geführter Federbalkenelemente F1, F2 zwischen zwei Einspannmitteln E1, E2. Auf den Oberflächen beider Federbalkenelemente F1, F2 sind entsprechende Piezowandler P zur aktiven Einflussnahme der Flächensteifigkeit eines Federbalkenelementes F1, F2 vorgesehen.

Durch die parallel geführte Doppelanordnung zweier Federbalkenelemente F1, F2 zwischen den zwei Einspannmitteln E1, E2 ist die gegenseitige Relativbewegung der beiden Einspannmittel mechanisch zwangsgeführt, so dass die Einspannmittel lediglich parallel zueinander ausgelenkt werden können (siehe hierzu Bewegungspfeile PL).

Das in Figur 4 dargestellte Ausführungsbeispiel einer konkret ausgebildeten Koppelstruktur sieht jeweils zwischen zwei Einspannmittel zwei parallel geführte Federbalkenelemente vor. Beginnend mit dem Einspannmittel E1, an dem der Körper K1 anbringbar ist, sind die Blattfederelemente 1 jeweils parallel geführt und stirnseitig fest eingespannt. Die parallelen Federbalkenelemente 1 sind andererseits mit dem Einspannmittel E2 fest verbunden, an dem die zweiten Federbalkenelemente 2 einseitig fest eingespannt sind. Nicht ersichtlich ist die rückseitige Einspannung der Federbalkenelemente 2 am dritten Einspannmittel E3, das getrennt vom ersten Einspannmittel E1 ausgebildet ist und einen über den ersten und zweiten Federbalkenelementen liegenden U-förmigen Abschnitt aufweist. Zwischen den Abschnittsenden des U-förmigen Abschnittes sind jeweils die dritten Blattfederelemente 3 angebracht, die jeweils mittig mit dem vierten Einspannmittel E4 verbunden sind, an dem der jeweils zweite Körper K2 fest verbindbar ist.

Anhand der perspektivischen Darstellung gemäß Figur 4 kann die jeweilige Flächenorientierung der Federbalkenelemente 1,2,3 entnommen werden, die im lösungsgemäßen Sinne mit jeweils orthogonal zueinander orientierten Normalenvektoren angeordnet sind.

Nur der guten Ordnung halber sei darauf hingewiesen, dass die Federbalkenelemente 1, 2, 3 mit jeweils flächig ausgebildeten Aktoren sowie Sensoren verbunden sind, um eine unmittelbare Einflussnahme auf die Flächensteifigkeit der einzelnen Federbalkenelemente nehmen zu können.

Durch die kompakte Bauweise ist es zudem möglich die lösungsgemäße Vorrichtung in beliebiger Weise modular durch serielle oder parallele Kopplung mit weiteren baugleichen oder in unterschiedlicher Bauform und Größe ausgebildeten Vorrichtungen zur mechanischen Schwingungsentkopplung zu kombinieren.

Die lösungsgemäße Vorrichtung lässt sich überall dort einsetzen, wo die Forderung nach einer möglichst schwingungsarmen Lagerung eines Körpers oder Gerätes relativ zur Umgebung besteht. Insbesondere bei empfindlichen Mess- und Analysegeräten, wie bspw. Mikroskopen ist eine aktive Lagerung des jeweiligen Messgerätes erforderlich. In gleicher Weise können derartige aktive Lagerungen in präzisen Fertigungsanlagen integriert werden, bspw. in der Chipindustrie.

### Bezugszeichenliste

- E1: erstes Einspannmittel
- E2: zweites Einspannmittel
- E3: drittes Einspannmittel
- E4: viertes Einspannmittel
- 1: erstes Federbalkenelement
- 2: zweites Federbalkenelement
- 3: drittes Federbalkenelement
- 4: viertes Federbalkenelement
- A: Aktor
- S: Sensor
- K1,K2: Körper
- V1, V2, V3: Normalenvektor
- E: Einspannmittel
- F: Federbalkenelement
- PL: Schwingungsrichtung
- P: Piezoaktor

## Patentansprüche

1. Vorrichtung zur mechanischen Schwingungsentkopplung, mit zwei Lagerenden, an die jeweils gegenseitig schwingungszuentkoppelnde Körper fügbar oder gefügt sind und die über eine Koppelstruktur mit einer variabel einstellbaren Steifigkeit miteinander verbunden sind,
**dadurch gekennzeichnet, dass** die Koppelstruktur wenigstens drei Federbalkenelemente aufweist, deren jeweils zuordenbare Federbalkenfläche durch einen Normalenvektor charakterisiert ist und die jeweils formstabil längs und elastisch orthogonal zur Federbalkenfläche sind,
dass die wenigstens drei Federbalkenelemente räumlich zueinander derart angeordnet sind, dass deren Normalenvektoren jeweils unter einem Winkel α zueinander orientiert sind, mit α =90° ± 30°,
dass die Federbalkenelemente jeweils zwei sich gegenüberliegende Federbalkenenden besitzen, die jeweils an einem Einspannmittel fest eingespannt sind,
dass ein erstes und ein letztes Einspannmittel jeweils mit einem unterschiedlichen Lagerende verbunden sind,
dass die übrigen Einspannmittel jeweils zwei Federbalkenelemente miteinander fest verbinden, und
dass die übrigen Einspannmittel (E2, E3) ausschließlich von den Federbalkenelementen (1, 2, 3) getragen werden und ansonsten frei schwingend gelagert sind.

2. Vorrichtung nach Anspruch 1,
**dadurch gekennzeichnet, dass** längs wenigstens eines Federbalkenelementes ein Mittel zur Beeinflussung der Elastizität bzw. Steifigkeit orthogonal zur Federbalkenfläche angebracht ist.

3. Vorrichtung nach Anspruch 2,
**dadurch gekennzeichnet, dass** das Mittel zur Beeinflussung der Elastizität orthogonal zur Federbalkenfläche Wandlermaterial aufweist, das durch eine Formänderung elektrische Energie zu erzeugen in der Lage ist und umgekehrt.

4. Vorrichtung nach einem der Ansprüche 1 bis 3,
**dadurch gekennzeichnet, dass** längs wenigstens eines Federbalkens wenigstens ein aus Wandlermaterial bestehender Aktor sowie wenigstens ein aus Wandlermaterial bestehender Sensor appliziert oder innerhalb des Federelementes integriert ist.

5. Vorrichtung nach Anspruch 4,
**dadurch gekennzeichnet, dass** der Aktor sowie der Sensor aus piezoelektrischem Material bestehen.

6. Vorrichtung nach einem der Ansprüche 1 bis 5,
**dadurch gekennzeichnet, dass** zu wenigstens einem zwischen zwei Einspannmitteln fest eingespannter Federbalken wenigstens ein zweiter Federbalken, der parallel und beabstandet zu dem einen angeordnet ist, zwischen den zwei Einspannmitteln eingespannt ist.

7. Vorrichtung nach einem der Ansprüche 1 bis 6,
**dadurch gekennzeichnet, dass** ein erstes, zweites, drittes und ein viertes Einspannmittel vorgesehen sind, von denen das erste mit dem einem Lagerende und einem ersten Federbalkenelement,
das vierte mit dem anderen Lagerende und einem dritten Federbalkenelement,
das zweite mit dem ersten und einem zweiten Federbalkenelement und das dritte mit dem zweiten und dem dritten Federbalkenelement verbunden sind.

8. Vorrichtung nach einem der Ansprüche 1 bis 7,
**dadurch gekennzeichnet, dass** wenigstens ein Lagerende Teil eines schwingenden Körpers ist.

9. Vorrichtung nach einem der Ansprüche 1 bis 8,
**dadurch gekennzeichnet, dass** wenigstens zwei Vorrichtungen, eine erste und eine zweite Vorrichtung, nach einem der Ansprüche 1 bis 8, jeweils ein erstes und ein zweites Lagerende vorsehen und derart ausgebildet und angeordnet sind,
dass zur Realisierung einer seriellen Kopplung beider Vorrichtungen das zweite Lagerende der ersten Vorrichtung fest mit dem ersten Lagerende der zweiten Vorrichtung gekoppelt ist, oder
dass zur Realisierung einer parallelen Kopplung beider Vorrichtungen die jeweils ersten Lagerenden und die jeweils zweiten Lagerenden beider Vorrichtungen fest miteinander gekoppelt sind.

10. Vorrichtung nach einem der Ansprüche 1 bis 9,
**dadurch gekennzeichnet, dass** die Normalenvektoren der wenigstens drei Federbalkenelemente orthogonal zueinander angeordnet sind, d.h. α =90°.

11. Vorrichtung nach einem der Ansprüche 1 bis 10,
**dadurch gekennzeichnet, dass** die Einspannmittel aus einem starren, ihre Form unveränderlich beibehaltenden Material gefertigt sind.

12. Vorrichtung nach einem der Ansprüche 1 bis 11,
**dadurch gekennzeichnet, dass** zwei über ein Einspannmittel miteinander verbundene Federbalkenelemente einen unveränderlichen Winkel β, mit β vorzugsweise 90° einschliessen.

## Claims

1. Device for mechanical vibration decoupling having two bearing ends onto each of which bodies for reciprocally decoupling vibrations can be joined or are joined and which are interconnected via a coupling structure with a variably adjustable stiffness,
**characterised in that** the coupling structure has at least three spring beam elements of which the spring beam surface which can be assigned in each case is **characterised by** a normal vector and which are each dimensionally stable longitudinally and elastically orthogonally to the spring beam surface,
in that the at least three spring beam elements are also arranged spatially with respect to each other in such a way that their normal vectors form an angle α, whereby α=90°±30
in that the spring beam elements each have two mutually opposite spring beam ends, each of which is firmly clamped in a clamping means,
in that a first and a last clamping means are each connected to a different bearing end,
in that the other clamping means firmly connect two spring beam elements to each other, and
in that the other clamping means (E2, E3) are exclusively carried by the spring beam elements (1, 2, 3) and are otherwise mounted in a freely oscillating manner.

2. Device in accordance with claim 1,
**characterised in that** a means for influencing the elasticity/stiffness is arranged along at least one spring beam element orthogonally to the spring beam surface.

3. Device in accordance with claim 2,
**characterised in that** the means for influencing the elasticity orthogonally to the spring beam surface comprises a transducer material which is able to produce electrical energy through changing shape and vice-versa.

4. Device in accordance with any one of claims 1 to 3,
**characterised in that** at least one actuator made of transducer material as well as at least one sensor made of transducer material is applied along at least one spring beam or is integrated within the spring element.

5. Device in accordance with claim 4,
**characterised in that** the actuator as well as the sensor are made of piezoelectric material.

6. Device in accordance with any one of claims 1 to 5,
**characterised in that** to at least one spring beam firmly clamped between two clamping means at least one second spring beam, which is arranged in parallel and at a distance to the one, is clamped between the two clamping means.

7. Device in accordance with any one of claims 1 to 6,
**characterised in that** a first, second, third and a fourth clamping means are provided, of which the first is connected with one bearing end and a first spring beam element,
the fourth is connected with the other bearing end and a third spring beam element,
the second is connected with the first and a second spring beam element and the third is connected with the second and the third spring beam element.

8. Device in accordance with any one of claims 1 to 7,
**characterised in that** at least one bearing end is part of a vibrating body.

9. Device in accordance with any one of claims 1 to 8,
**characterised in that** at least two devices, a first and a second device in accordance with any one of claims 1 to 8, each have a first and a second bearing end and are designed and arranged in such a way that to bring about series coupling of both devices the second bearing end of the first device is firmly coupled to the first bearing end of the second device, or
to bring about parallel coupling of both devices the first bearing ends and the second bearing ends of the two devices are each firmly connected to each other.

10. Device in accordance with any one of claims 1 to 9,
**characterised in that** the normal vectors of the at least three spring beam elements are arranged orthogonally with regard to each other, i.e. α = 90°.

11. Device in accordance with any one of claims 1 to 10,
**characterised in that** the clamping means are made of a rigid material that retains its shape unchanged.

12. Device in accordance with any one of claims 1 to 11,
**characterised in that** two spring beam elements connected to each other via a clamping means assume an invariable angle ß, where ß is preferably 90°.

## Revendications

1. Dispositif de découplage mécanique d'oscillations avec deux extrémités de logement auxquelles peuvent être joints ou sont joints des corps à découpler en oscillation à chaque fois réciproquement et qui sont reliées l'une à l'autre par une structure d'accouplement présentant une rigidité réglable de manière variable, **caractérisé en ce que** la structure d'accouplement présente au moins trois éléments à barre de ressort dont chaque surface de barre à ressort associable est **caractérisée par** un vecteur normal et qui présentent chacun une forme stable dans le sens longitudinal et sont élastiques dans le sens orthogonal par rapport à la surface de barre de ressort, en ce que lesdits au moins trois éléments à barre de ressort sont disposés l'un par rapport à l'autre dans l'espace de manière que leurs vecteurs normaux sont orientés l'un par rapport à l'autre à un angle α, où α = 90° ± 30°, en ce que les éléments à barre de ressort présentent chacun deux extrémités de barre de ressort opposées l'une à l'autre qui sont fermement enserrées dans un moyen de serrage, en ce qu'un premier et un dernier moyen de serrage sont chacun assemblés à une extrémité de logement différente, en ce que les autres moyens de serrage relient respectivement deux éléments à barre de ressort de manière fixe l'un à l'autre, et en ce que les autres moyens de serrage (E2, E3) sont exclusivement supportés par les éléments à barre de ressort (1, 2, 3) et sont pour le reste logés en pouvant osciller librement.

2. Dispositif selon la revendication 1, **caractérisé en ce que** le long d'au moins un élément à barre de ressort est monté un moyen destiné à influencer l'élasticité ou la rigidité de manière orthogonale par rapport à la surface à barre de ressort.

3. Dispositif selon la revendication 2, **caractérisé en ce que** le moyen destiné à influencer l'élasticité de manière orthogonale par rapport à la surface à barre de ressort comporte un matériel convertisseur qui, par une modification de forme, est en mesure de produire de l'énergie électrique et inversement.

4. Dispositif selon l'une quelconque des revendications 1 à 3, **caractérisé en ce que** le long d'au moins une barre de ressort un actionneur composé d'un matériel convertisseur ainsi qu'au moins un capteur composé d'un matériel convertisseur est appliqué ou intégré à l'intérieur de l'élément de ressort.

5. Dispositif selon la revendication 4, **caractérisé en ce que** l'actionneur ainsi que le capteur sont en matériau piézoélectrique.

6. Dispositif selon l'une quelconque des revendications 1 à 5, **caractérisé en ce qu'**à au moins une barre de ressort enserrée entre deux moyens de serrage, est enserrée entre les deux moyens de serrage, au moins une deuxième barre de ressort, qui est disposée parallèle et à distance de celle-ci.

7. Dispositif selon l'une quelconque des revendications 1 à 6, **caractérisé en ce qu'**un premier, deuxième, troisième et quatrième moyen de serrage sont prévus, dont le premier est relié à la une extrémité de logement et un premier élément de ressort, le quatrième est relié à l'autre extrémité de logement et un troisième élément de ressort, le deuxième est relié au premier et à un deuxième élément à barre de ressort et le troisième au deuxième et au troisième élément à barre de ressort.

8. Dispositif selon l'une quelconque des revendications 1 à 7, **caractérisé en ce qu'**au moins une extrémité de logement fait partie d'un corps oscillant.

9. Dispositif selon l'une quelconque des revendications 1 à 8, **caractérisé en ce qu'**au moins deux dispositifs, un premier et un deuxième dispositif, prévoient, selon l'une quelconque des revendications 1 à 8, respectivement une première et une deuxième extrémité de logement et sont constituées et disposés de telle sorte que pour réaliser un accouplement en série des deux dispositifs, la deuxième extrémité de logement du premier dispositif est fermement accouplée à la première extrémité de logement du deuxième dispositif, ou **en ce que** pour réaliser un accouplement parallèle des deux dispositifs, lesdites premières extrémités de logement et lesdites deuxièmes extrémités de logement sont chacune fixement reliées l'une à l'autre.

10. Dispositif selon l'une quelconque des revendications 1 à 9, **caractérisé en ce que** les vecteurs normaux des au moins trois éléments à barre de ressort sont disposés de façon orthogonale l'un par rapport à l'autre, c'est-à-dire α = 90°.

11. Dispositif selon l'une quelconque des revendications 1 à 10, **caractérisé en ce que** les moyens de serrage sont fabriqués dans un matériau rigide, maintenant leur forme inaltérable.

12. Dispositif selon l'une quelconque des revendications 1 à 11, **caractérisé en ce que** deux éléments à barre de ressort reliés entre eux par un moyen de serrage comprennent un angle β inaltérable, avec β de préférence à 90°.
